Europäisches Patentamt

European Patent Office

Office européen des brevets

(11) Publication number: **0 162 225**
**B1**

## EUROPEAN PATENT SPECIFICATION

(45) Date of publication of patent specification: **26.10.88**

(21) Application number: **85103414.0**

(22) Date of filing: **22.03.85**

(51) Int. Cl.[4]: **G 06 G 7/12,** H 03 K 19/094,
H 03 K 5/24

(54) Fuzzy logic circuit.

(30) Priority: **23.03.84 JP 57124/84**

(43) Date of publication of application:
**27.11.85 Bulletin 85/48**

(45) Publication of the grant of the patent:
**26.10.88 Bulletin 88/43**

(84) Designated Contracting States:
**AT BE CH DE FR GB IT LI LU NL SE**

(56) References cited:
DE-B-1 293 844
US-A-4 338 527

TRANSACTIONS OF THE INST. ELECTRON. &
COMMUN. ENG. OF JAPAN, Part E, vol. E64,
no. 2, February 1981; T. YAMAKAWA et al. "
Implementation of fuzzy logic circuits and a
programmable multifunction circuit with
current mode", page 105 & Vol. J64-C, no. 2,
pages 147-148

(73) Proprietor: **OMRON TATEISI ELECTRONICS CO.**
**10, Tsuchido-cho Hanazono Ukyo-ku**
**Kyoto 616 (JP)**

(72) Inventor: **Ueno, Fumio**
**c/o Omron Tateisi Electronics Co. (Patent**
**Center)**
**Shimo-Kaiinji Nagaokakyo-Shi Kyoto (JP)**
Inventor: **Yamakawa, Takeshi**
**c/o Omron Tateisi Electronics Co. (Patent**
**Center)**
**Shimo-Kaiinji Nagaokakyo-Shi Kyoto (JP)**
Inventor: **Shirai, Yuji**
**c/o Omron Tateisi Electronics Co. (Patent**
**Center)**
**Shimo-Kaiinji Nagaokakyo-Shi Kyoto (JP)**

(74) Representative: **WILHELMS, KILIAN & PARTNER**
**Patentanwälte**
**Eduard-Schmid-Strasse 2**
**D-8000 München 90 (DE)**

Courier Press, Leamington Spa, England.

**0 162 225**

(56) References cited:

TRANSACTIONS OF THE INST. ELECTRON. &
COMMUN. ENG. OF JAPAN, Part E, vol. E63,
no. 10, October 1980; T. YAMAKAWA et al.
"Implementation of Fuzzy Logic (complement,
bounded-difference, bounded-sum and
absolute-difference) by current-mode circuits",
pag

TRANSACTIONS OF THE INST. ELECTRON. &
COMMUN. ENG. OF JAPAN, Part C, vol. J67C,
no. 12, December 1984; T. YAMAKAWA et al.
"Basic fuzzy logic circuit formed by using
p-MOS current mirror circuits", page 1022-1029

## Description

The present invention relates to a fuzzy logic circuit.

Fuzzy logic handles fuzziness; i.e., human thought and behavior involve indefiniteness or vagueness. If such vagueness can be expressed in terms of a number or amount or theorized, the result will find application to the design of community systems such as traffic control systems, emergency or applied therapeutic systems and the like, and to the design of robots simulating the humans. Ever since the concept of fuzzy sets was proposed by L. A. Zadeh in 1965, research has been conducted on fuzzy logic as a means for handling "vagueness" from the above viewpoint. However, many research efforts are presently directed to the application of fuzzy logic to software systems for use with digital computers. The digital computer is adapted to perform operations based on the binary logic with use of 0 and 1. Although the operation is processed very strictly, there is a need to use an A/D converter circuit for feeding analog amounts. Accordingly the computer has the problem of requiring a long period of time to obtain the final result by processing a vast quantity of information. The programs for handling fuzzy logic are bound to become complex and require a large-sized digital computer for complicated processing, hence they are uneconomical.

Since fuzzy logic handles continuous values (0, 1) in the section of from 0 to 1, the logic is inherently incompatible with digital computers which operate on binary logic. Further because fuzzy logic handles vague amounts having a range, the strictness required thereof is not as high as is required of digital computers. Accordingly, it is desired to provide circuits or systems which are suitable to handle fuzzy logic.

Transactions of the Inst. Electron. and Comm. Eng. of Japan, Part E, Volume E64, No. 2, February 1981, page 105 & Volume J64/C, No. 2, pages 147—148 and Transactions of the Inst. Electron. and Comm. Eng. of Japan, Part E, Volume E63, No. 10, October 1980, page 790 & Volume J63/C, No. 10, pages 722—723 show fuzzy logic circuits with a current mirror circuit having a first input current source connected to the input side of the current mirror, a second input current source, a wired OR connected at its input side to the output side of the current mirror and to the second input current source, and an output terminal connected to the output side of the wired OR. Such circuit forms a basic current-mode circuit suitable for realizing a bounded-difference circuit.

The object underlying the invention is to provide an implication circuit making use of basic circuits as mentioned above.

This object is accomplished according to an implication circuit as claimed in claim 1.

A preferred embodiment of the invention will now be described in connection with the accompanying drawings, in which

Fig. 1 shows current input-output modes;

Fig. 2 is a diagram showing a bounded-difference circuit;

Fig. 3 is a graph showing the input-output characteristics of the same;

Fig. 4 is a circuit diagram of two equivalent current mirrors;

Fig. 5 shows the construction of an integrated bounded-difference circuit, (A) being a pattern plan view, (B) being a view in section taken along the line b—b in (A), and (C) being a view in section taken along the line c—c in (A);

Fig. 6 is a diagram showing a bounded-difference circuit comprising an N-MOS FET;

Fig. 7 is a diagram showing an implication diagram;

Fig. 8 shows an IC pattern of the same, (A) being a plan view, and (B) being a view in section taken along the line b—b in (A).

1) Current input-output modes in fuzzy logic circuits

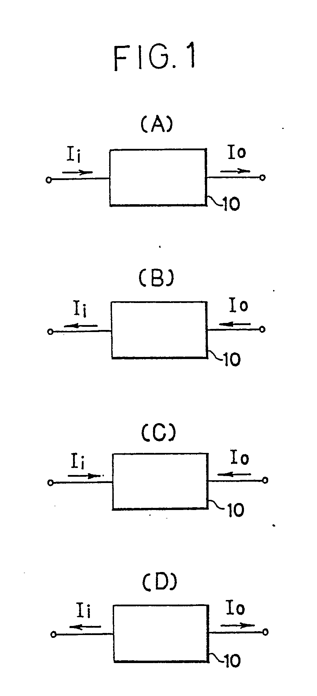

According to the present invention, the fuzzy logic circuit operates in a current mode. Various current input-output modes will be described briefly. In Fig. 1, the input current of a fuzzy logic circuit 10 is indicated at Ii, and the output current thereof at Io. (A) shows an input-output mode in which the input current Ii flows into the circuit 10 and the output current Io flows out from the circuit 10. Such currents will be referred to as "flow-in input" and "flow-out output". In (B), the input current Ii flows out from the circuit 10, and the output current Io flows into the circuit 10, hence flow-out input and flow-in output. Similarly (C) shows flow-in input and flow-in output, and (D) shows flow-out input and flow-out output. When connecting fuzzy logic circuits in cascade, the mode of Fig. 1 (A) or (B) is preferable to use. While Fig. 1 shows examples of single fan-in and single fan-out, like input-output modes are used for multiple fan-in/fan-out circuits.

2) Basic operations of fuzzy logic

A fuzzy set X is characterized by a membership function $\mu x$. The membership function represents the degree to which a variable thereof belongs to the fuzzy set X. This degree is expressed by a continuous value (0, 1) in the section of from 0 to 1. Accordingly, the membership function can be said to convert the variable to (0, 1). Similarly, a fuzzy set Y is characterized by a membership function $\mu y$.

According to the fuzzy logic, vagueness is expressed by a fuzzy set, which is used for handling the vagueness of a common logic. The basic fuzzy logic includes bounded difference, complement, bounded sum, bounded product, logic union, logic intersection, absolute difference, implication and equivalence. These nine basic operations can be expressed by bounded difference and arithmetic sum. This means that the smallest units of the basic operations of fuzzy logic are bounded difference and arithmetic sum. One of the advantages of circuits which operate in current mode is that the arithmetic summation (arithmetic subtraction also) can be realized by a wired OR.

As a rule, circuits for carrying out the basic operations are provided by P-channel metal-oxide-semiconductor field-effect transistors (P-MOS FET), and the current mode of flow-out input/flow-in output is used. However, fuzzy logic circuits can be realized also by N-channel MOS FET and complementary MOS FET (N-MOS FET and C-MOS FET).

3) Bounded-difference circuit

For fuzzy sets X, Y, the bounded difference is defined as follows with use of their membership functions $\mu x$, $\mu y$.

$$X \ominus Y <=> \mu_{x \ominus y}$$
$$\equiv \mu x \ominus \mu y$$
$$= 0V(\mu x - \mu y) \qquad (1)$$

wherein $\ominus$ is bounded difference, V is logic union (max) (the greatest should be selected), and $-$ represents arithmetic subtraction. The fuzzy logic does not use negative values, so that when $(\mu x - \mu y)$ in Expression (1) is a negative value, the bounded difference becomes 0 owing to the logic union V. Specifically, Expression (1) represents the following relation.

$$\mu_{x \ominus y} = \begin{cases} \mu x - \mu y & (\mu x > \mu y) \\ 0 & (\mu x \leqq \mu y) \end{cases} \qquad (2)$$

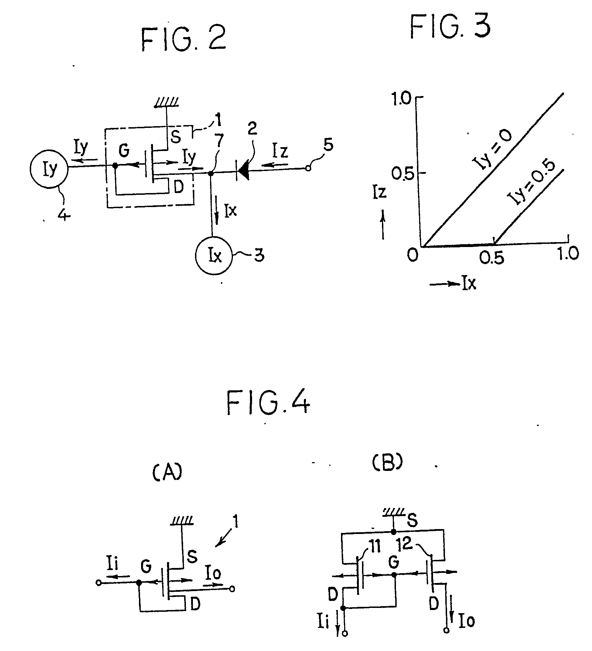

Fig. 2 shows a bounded-difference circuit, which comprises a current mirror 1 comprising a P-MOS FET, a wired OR 7, a diode 2, two current sources 3, 4 and an output terminal 5. The current mirror 1, which is shown also in Fig. 4 (A), is equivalent to a current mirror shown in Fig. 4 (B) and comprising two P-MOS FET 11, 12.

With reference to Fig. 4 (B), the source S of the two FET's 11, 12 is grounded. The gates G thereof are connected together and further connected to the drain D of one FET 11. When a flow-out input Ii is given to the drain D of the FET 11, a flow-out output current Io (=Ii) is obtained from the drain D of the other FET 12. This is because a gate voltage (between the gate and the source S) is applied so that the drain current becomes equal to Ii in the FET 11 and because this gate voltage also acts on the other FET 12 to make the drain current of the FET 12 also equal to Ii, provided that the two FET's 11, 12 are equivalent in structure and Si-SiO$_2$ interface properties. No current flows through the short circuit between the gate G and the drain D of the FET 11.

If the two FET's are identical in structure and Si-SiO$_2$ interface properties, an output current Io equal to the input current Ii is obtained irrespective of the intensity of the input current. This is a distinct feature of current mirrors comprising FET's. With current mirrors comprising bipolar elements such as common p-n junction transistors the relation of Ii=Io is available only when the current amplification factor $\beta$ is very great. If the input current Ii is small, the factor $\beta$ is also small, so that the above relation is not obtained. The current mirror of Fig. 4 (B) will hereinafter be referred to by the symbol used in Fig. 4 (A).

Referring to Fig. 2 again, when the current source 4 for giving a flow-out input current Iy is connected to the input drain (gate) of the current mirror 1, a flow-out current of equal value Iy is obtained at the output drain, as will be apparent from the above description. Connected by way of the wired OR 7 to the output drain are the current source 3 for giving a flow-out input current Ix and the output terminal 5, the latter being so connected via a diode 2 which is backward with respect to the direction of outflow of the mirror. Since the current of value Ix is drawn by the current source 3, an output current of Iz=Ix−Iy flows from the terminal 5 through the diode 2 into the source 3 only when Ix is greater than Iy. If Ix is not greater than Iy, an output current of Iy−Ix is to flow out, but this current is blocked by the diode 2, with the result that the output current toward the terminal 5 is zero.

The above relation will be expressed as follows.

$$Iz = \begin{cases} Ix - Iy & (Ix > Iy) \\ 0 & (Ix \leqq Iy) \end{cases} \qquad (3)$$

When the membership functions $\mu x$, $\mu y$ are made to correspond to the input currents Ix, Iy, respectively, and the bounded difference $\mu_{x \ominus y}$ to the output current Iz, Expression (3) represents exactly the same relation as Expression (2). It will be understood that the circuit of Fig. 2 is the basic operation circuit for bounded difference.

Fig. 3 shows the relation between the input current Ix and the output current Iz when the other input current Iy is used as a parameter. In this case, both input and output currents are so normalized that the maximum will be 1.

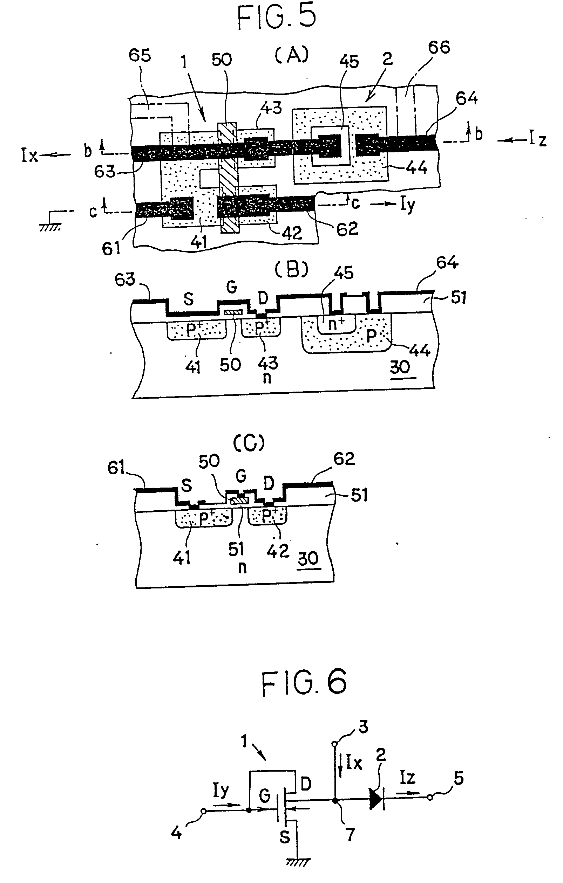

Fig. 5 shows an example of integrated circuit (IC) structure into which the bounded-difference circuit of Fig. 2 is built. The substrate (second gate) is not shown. The circuit can be formed on an n-type base plate 30 by the common process for fabricating P-MOS.

An A1 (conductor) pattern 61 serving as the source of the current mirror 1 is in ohmic contact with a p-region 41. An A1 pattern 62 serving as the input drain is connected to a p-region 42. An A1 pattern 63 providing the output drain is also connected to a p-region 43. The two FET's are made identical in channel width, channel length and thickness of the gate oxide layer. A polycrystal Si (B doped, p-type) 50 serving as the gate is enclosed by an insulating layer 51 and is positioned between the p-region 41 and p-regions 42, 43. The polycrystal Si 50, which is connected to the A1 pattern 62, is insulated from the A1 pattern 63 by the layer 51 which is made of SiO$_2$. A p-region 44 and an n-region 45 provide the diode 2. The A1 pattern 63 extends over and is connected to the n-region which serves as a cathode. An A1 pattern 64 connected to the output terminal 5 is connected to the p-region 44.

Fig. 6 shows a bounded-difference circuit provided by an N-MOS FET. The current input-output mode is flow-in input/flow-out output. The FET is also provided with two drains, one connected to the gate and the other to the output side. The source is grounded. The diode 2 is oriented of course in a reverse direction to the one shown in Fig. 2. The operation of Expression (3) can be performed also by this circuit.

In Fig. 6, the current sources are replaced by input terminals 3, 4. For the sake of simplification, this manner will be used in the following description.

4) Implication circuit

For the fuzzy sets X, Y, the implication $(\bar{x}vy; x\bar{v}y)$ is defined as follows by their membership functions $\mu x$, $\mu y$.

$$X{\rightarrow}Y<=>\mu_{x{\rightarrow}y}$$
$$\equiv 1{\wedge}(1-\mu x+\mu y) \qquad (32)$$

Since $\mu x$ represents the degree of belonging to the set X, $(1-\mu x)$ represents the degree of not belonging to the set X. Further for the logic intersection $\wedge$, the smaller is to be selected. In view of the above, implication represents the arithmetic sum of the above two kinds of degrees, and means that when the sum is greater than 1, 1 is taken as the result. For a better understanding, Expression (32) will be modified as follows:

$$1{\wedge}(1-\mu x+\mu y)$$
$$= \begin{cases} 1-\mu x+\mu y & (\mu x>\mu y) \\ 1 & (\mu x{\leqq}\mu y) \end{cases} \qquad (33)$$

Further Expression (32) can also be modified as follows:

$$1{\wedge}(1-\mu x+\mu y)$$
$$=1{\ominus}(\mu x{\ominus}\mu y) \qquad (34)$$

Expression (34) can be established as follows:

$$1{\ominus}(\mu x{\ominus}\mu y)\equiv 1{\ominus}(x{\ominus}y)$$
$$=0V[1-(x{\ominus}y)]$$
$$=0V[1-[0V(x-y)]]$$
$$=0V[(1-0){\wedge}(1-(x-y))]$$
$$=0V[1{\wedge}(1-x+y)]$$
$$=1{\wedge}(1-x+y)$$
$$\equiv 1{\wedge}(1-\mu x+\mu y) \qquad (35)$$

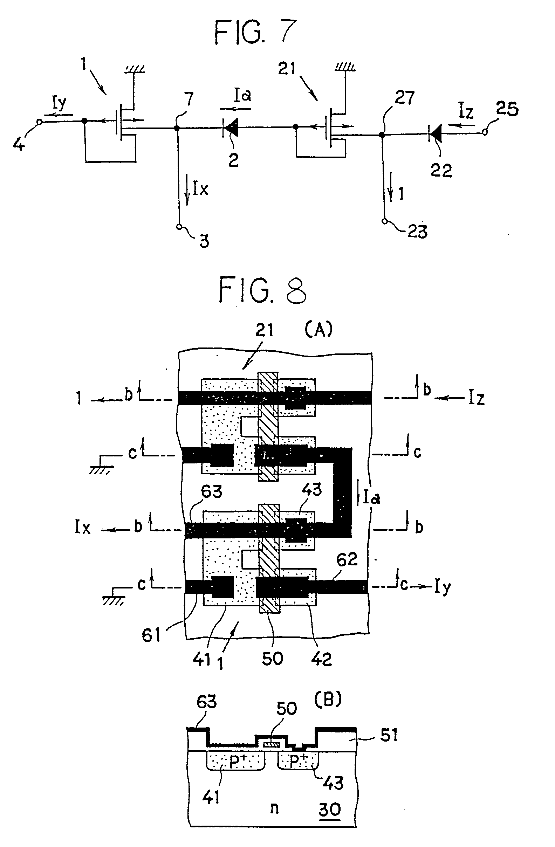

Expression (34) shows that the operation for the implication can be realized by two bounded-difference circuits. Fig. 7 shows an implication circuit. With reference to the diagram, the output current la of the bounded-difference circuit in the first stage is given by:

$$la= \begin{cases} lx-ly & (lx>ly) \\ 0 & (lx{\leqq}ly) \end{cases} \qquad (36)$$

This current Is serves as one input current for the bounded-difference circuit in the second stage, while a current having a value of 1 is given as the other input current (terminal 23). Accordingly the output current lz of the second circuit is given by:

$$lz= \begin{cases} 1-lx+ly & (lx>ly) \\ 1 & (lx{\leqq}ly) \end{cases} \qquad (37)$$

By making Expression (37) correspond to Expression (33) it is seen that the operation for the implication is performed.

With reference to Fig. 7, the diode 2 can be omitted since no current is likely to flow into the gate of the current mirror 21 of the latter-stage bounded difference circuit. Because the current (equal to la) flowing out from the output drain of the current mirror 21 in the second stage is unlikely to become greater than the input current 1 of the terminal 23, the diode 22 can also be omitted. Accordingly, when the implication circuit of Fig. 7 is to be made into an IC, the diodes 2, 22 need not be provided as shown in Fig. 8 (A). In Fig. 8 (A), the c—c section is the same as the one shown in Fig. 5 (B).

**Claims**

1. A fuzzy implication circuit (Fig. 7) comprising:
a first fuzzy bounded-difference circuit having as its inputs (3, 4) two currents (Ix, Iy) representing operation variables, and
a second fuzzy bounded-difference circuit having as its inputs the output current (la) of the first fuzzy bounded-difference circuit and a current representing the value 1 according to fuzzy logic and giving an output (Iz) representing the result of the fuzzy implication operation,
the first fuzzy bounded-difference circuit comprising a first current mirror (1) composed of a first FET, and a first wired OR (7) connected to the output side of the first current mirror, the second fuzzy bounded-difference circuit comprising a second current mirror (21) composed of a second FET, and a second wired OR (27) connected to the output side of the second current mirror.

2. A fuzzy implication circuit according to claim 1, in which the second bounded-difference circuit further comprises a diode (22) connected in a forward direction with respect to the direction of the output current (Iz).

**Patentansprüche**

1. Fuzzy-Implikationsschaltung (Fig. 7), welche umfaßt:
eine erste Fuzzy-Beschränktdifferenz-Schaltung, welche als ihre Eingänge (3, 4) zwei Ströme (Ix, Iy), die Operationsvariable darstellen, aufweist, und
eine zweite Fuzzy-Beschränktdifferenz-Schaltung, welche als ihre Eingänge den Ausgangsstrom (la) der ersten Fuzzy-Beschränktdifferenz-Schaltung und einen Strom, der den Wert 1 gemäß Fuzzy-Logik darstellt, aufweist und einen Ausgang (Iz) liefert, welcher das Ergebnis der Fuzzy-Implikations-Operation darstellt,
wobei die erste Fuzzy-Beschränktdifferenz-Schaltung einen aus einem ersten FET aufgebauten ersten Stromspiegel (1) und ein mit der Ausgangsseite des ersten Stromspiegels verbundenes erstes verdrahtetes ODER (7) umfaßt, wobei die zweite Fuzzy-Beschränktdifferenz-Schaltung einen aus einem zweiten FET aufgebauten zweiten Stromspiegel (21) und ein mit der Ausgangsseite des zweiten Stromspiegels verbundenes zweites verdrahtetes ODER (27) umfaßt.

2. Fuzzy-Implikationsschaltung nach Anspruch 1, bei welcher die zweite Beschranktdifferenz-Schaltung ferner eine in Vorwärtsrichtung in Bezug auf die Richtung des Ausgangsstromes (Iz) angeschlossene Diode (22) umfaßt.

## Revendications

1. Circuit réalisant une implication floue (figure 7) comprenant:

un premier circuit de flou à différence limitée recevant à ses entrées (3, 4) deux courants (Ix, Iy) représentant des variables opératoires, et

un second circuit de flou à différence limitée recevant à ses entrées le courant de sortie (Ia) du premier circuit de flou à différence limitée et un courant représentant la valeur 1 conformément à la logique floue et délivrant un signal de sortie (Iz) représentant le résultat de l'opération d'implication floue.

le premier circuit de flou à différence limitée comprenant un premier miroir de courant (1) constitué par un premier transistor FET, et un premier OU câblé (7) raccordé au côté sortie du premier miroir de courant, le second circuit de flou à différence limitée comprenant un second miroir de courant (21) constitué par un second transistor FET, et un second OU câblé (27) raccordé au côté sortie du second miroir de courant.

2. Circuit réalisant une implication floue selon la revendication 1, dans lequel le second circuit à différence limitée comporte en outre une diode (22) raccordée dans le sens passant par rapport au sens du courant de sortie (Iz).

# FIG.1

## (A)

$I_i$ →  ⬜ 10  → $I_o$

## (B)

$I_i$ ←  ⬜ 10  ← $I_o$

## (C)

$I_i$ →  ⬜ 10  ← $I_o$

## (D)

$I_i$ ←  ⬜ 10  → $I_o$

0 162 225

# FIG. 2

# FIG. 3

# FIG. 4

(A)

(B)

2

# FIG.5

## (A)

## (B)

## (C)

# FIG.6

## FIG. 7

## FIG. 8

(A)

(B)

4